# EUROPEAN PATENT SPECIFICATION

(11) **EP 0 532 575 B1**
(45) Date of publication and mention of the grant of the patent: **11.10.1995**
(21) Application number: 91910384.6
(22) Date of filing: 06.06.1991
(51) Int. Cl.: H03F 3/68, H04B 1/74

(54) **APPARATUS FOR DETECTING FAILURE OF AN ANTENNA AMPLIFIER UNIT WITH A HOT STANDBY REDUNDANCY**
GERÄT ZUR FEHLERDETEKTION EINES ANTENNENVERSTÄRKERS MIT MITLAUFENDER RESERVEREDUNDANZ
APPAREIL PERMETTANT DE DETECTER LA PANNE D'UN AMPLIFICATEUR D'ANTENNE AVEC REDONDANCE DE SECOURS AUTOMATIQUE

(30) Priority: 08.06.1990 FI 902884
(43) Date of publication of application: 24.03.1993
(73) Proprietor: NOKIA TELECOMMUNICATIONS OY, 02601 Espoo (FI)
(72) Inventor: SAVUSALO, Juha, SF-90500 Oulu (FI)
(74) Representative: Tomlinson, Kerry John
(86) International application number: FI9100180
(87) International publication number: WO9119348

(56) References cited:
- US-A- 3 305 791
- US-A- 3 345 578
- US-A- 4 565 972
- US-A- 4 748 423

## Description

The invention relates to an apparatus for detecting failure of an antenna amplifier unit, replicated on the hot standby principle, in a receiving unit positioned apart from an antenna, the receiving unit comprising power supply means for supplying operating voltage to the antenna amplifier unit through an antenna cable.

To improve the sensitivity of radio receivers, an antenna amplifier or preamplifier is often placed at the top of the antenna mast in close vicinity to the antenna, whereby a signal received by the antenna can be amplified before it is applied through an antenna cable to the primary receiver positioned at the foot of the mast or close to it see e.g. US-A-4 565 972. To increase the reliability and redundancy, the antenna amplifier is often replicated on the hot standby principle: both the amplifier in use and the amplifier in reserve assumes a full operating mode, so that when the amplifier in use fails, the signal can be passed immediately to the standby amplifier without interfering with the reception. The power source is usually positioned in connection with the receiver at the foot of the mast and the operating voltage is supplied to the amplifier positioned in the mast through the antenna cable, so that the need for a separate power supply cable is avoided.

A problem with such an arrangement is, however, that information concerning the failure of the amplifier positioned in the mast and the replacement of it with the other amplifier should be transmitted to the receiver in order to be able to start the required repair operations. One approach is to use an extra cable for the transmission of the alarm. This, however, is inconvenient if there are no provisions for extra cables. The need for an extra cable can be avoided by transmitting the alarm information in the form of a modulated signal through the antenna cable to the receiver. Among the disadvantages of this method are that it causes interferences and requires a complicated equipment with resulting costs.

The object of the present invention is to provide an apparatus by means of which alarm information can be transmitted from the mast simply and advantageously without the need for separate cables.

This is achieved by means of an apparatus of the type disclosed in the introduction, which according to the invention is characterized in that the antenna amplifier unit comprises control means responsive to a failure of an amplifier for disconnecting the amplifier from the supply of operating voltage, and that the power supply means are capable of detecting a change in power consumption resulting from the disconnection of the amplifier from the supply of operating voltage and thereby the failure of the amplifier.

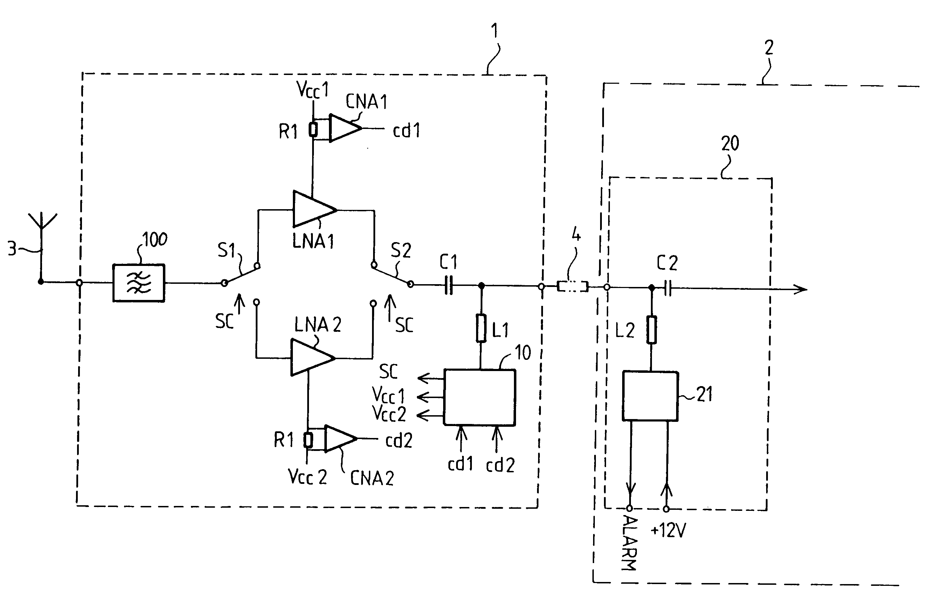

In the following the invention will be described in greater detail by means of an exemplifying embodiment with reference to the attached figure, which is a block diagram of an apparatus according to the invention.

The figure shows an antenna amplifier or preamplifier unit 1 positioned in close vicinity to a receiving antenna 3, e.g. in an antenna mast or some other place where the antenna is positioned, so as to amplify a radio-frequency signal received by the antenna 3 before the signal is applied through an antenna cable 4 to a receiving unit 2 positioned at a greater distance from the antenna, e.g. at the foot of the antenna mast or close to it. According to the requirements in each particular case, the receiving unit 2 may be of any type, such as a base station in a cellular mobile telephone system. The receiving unit 2 comprises a power source unit 20 for supplying operating voltage through a coaxial antenna cable 4 to the amplifier unit 1. Even though the power source unit 20 is considered to be a functional part of the receiving unit 2, it may be positioned in practice apart from the radio sections of the receiving unit 2.

The amplifier unit 1 comprises a bandpass filter 100 for separating a desired frequency band from the signal fed by the antenna 3. To assure the reliability and redundancy of the amplifier unit, it is replicated on the hot standby principle. For this purpose the unit comprises at least two separate high-frequency amplifiers LNA1 and LNA2 of which one serves as an active amplifier through which the signal is passed, and the other is in reserve ready for operation, that is, in a hot standby mode. For the selection of the amplifier, the amplifier unit 1 comprises a change-over switch S1, which connects the output of the filter 100 to the input of the amplifier LNA1 or LNA2, and a change-over switch S2 which connects, through a blocking capacitor C1, the output of the amplifier LNA1 or LNA2, respectively, to the output of the unit 1.

The amplifier unit 1 further comprises a control unit 10 which is connected through a coil L1 to the center wire of the coaxial antenna cable 4 for receiving operating voltage and for generating separate operating voltages Vcc1 and Vcc2 to be applied to the amplifiers LNA1 and LNA2. The control unit 10 monitors the condition of the amplifiers LNA1 and LNA2 by observing their power consumption by means of measuring circuits formed by resistors R1 and R2 and differential amplifiers CNA1 and CNA2, respectively. The measuring circuits produce signals cdl and cd2 proportional to the power consumption of the amplifiers LNA1 and LNA2, respectively. The signals are applied to the control unit 10, and when the control unit 10 detects, e.g. in the situation of the figure on the basis of the signal cdl, that the amplifier LNA 1 has a failure, it immediately changes the state of a switch control signal SC so that the switches S1 and S2 switch the received signal to pass through the amplifier LNA2. In addition, the control unit 10 disconnects the amplifier LNA1 from the supply of the operating voltage Vcc1. If, in the situation of the figure, the failing amplifier is the amplifier LNA2, the control unit 10 only cuts off the operating voltage Vcc2.

The power control unit 20 comprises a voltage source and control unit 21 which is connected through a coil L2 to the center wire of the antenna cable 4 for supplying the operating voltage +12V to the amplifier unit 1. The unit 21 monitors the power consumption of the amplifier unit 1 and when it detects a reduction in the power consumption as a result of an interruption in the supply of one of the operating voltages Vcc1 and Vcc2, indicating failure of one amplifier, it generates an alarm signal ALARM for the control system of the receiving unit 2 or the operating staff. The measuring of the power consumption and the generation of the alarm signal can be realized in many ways obvious to one skilled in the art.

The figure and the description related to it are only intended to illustrate the present invention. In its details, the apparatus of the invention may vary within the scope of the attached claims.

## Claims

1. Apparatus for detecting failure of an amplifier in an antenna amplifier unit (1), the amplifier being replicated on the hot standby principle, the input of the antenna amplifier unit being directly connected to an antenna (3) and the output being connected to a receiving unit (2) through an antenna cable (4), said apparatus for detecting failure being in said receiving unit which is positioned apart from said antenna, the receiving unit comprising power supply means (20) for supplying operating voltage to the antenna amplifier unit through said antenna cable, **characterized** in that the antenna amplifier unit comprises control means (10) responsive to a failure of an amplifier for disconnecting the amplifier (LNA1, LNA2) from the supply of operating voltage, and that the power supply means are capable of detecting a change in power consumption resulting from the disconnection of the amplifier from the supply of operating voltage and thereby the failure of the amplifier (LNA1, LNA2).

## Patentansprüche

1. Vorrichtung zur Abtastung eines Ausfalls eines Verstärkers in einer Antennenverstärkereinheit (1), wobei der Verstärker nach dem Hot-standby-Prinzip arbeitet, wobei der Eingang der Antennenverstärkereinheit direkt mit einer Antenne (3) verbunden ist und der Ausgang über ein Antennenkabel (4) mit einer Empfängereinheit (2) verbunden ist, wobei die Vorrichtung zum Abtasten eines Ausfalles in der Empfängereinheit vorgesehen ist, die getrennt von der Antenne positioniert ist, wobei die Empfängereinheit eine Stromversorgungseinrichtung (20) aufweist, um der Antennenverstärkereinheit über das Antennenkabel eine Betriebsspannung zuzuführen,
dadurch gekennzeichnet,
daß die Antennenverstärkereinheit eine Steuereinrichtung (10) aufweist, die auf einen Ausfall eines Verstärkers anspricht, um den Verstärker (LNA1, LNA2) von der Versorgung der Betriebsspannung abzutrennen,
und daß die Stromversorgungseinrichtung in der Lage ist, eine Änderung des Energieverbrauches festzustellen, der aus der Abtrennung des Verstärkers von der Versorgung der Betriebsspannung und somit dem Ausfall des Verstärkers (LNA1, LNA2) resultiert.

## Revendications

1. Appareil pour détecter la panne d'un amplificateur dans un dispositif d'amplificateur (1) d'antenne, l'amplificateur étant doublé selon le principe de mise en attente sous tension, l'entrée du dispositif d'amplificateur d'antenne étant directement reliée à une antenne (3) et la sortie étant reliée par un câble (4) d'antenne à un dispositif de réception (2), ledit appareil de détection de panne étant dans ledit dispositif de réception disposé à l'écart de ladite antenne, le dispositif de réception comprenant un moyen (20) d'alimentation électrique pour fournir par ledit câble d'antenne une tension de fonctionnement du dispositif d'amplificateur d'antenne, caractérisé en ce que le dispositif d'amplificateur d'antenne comprend un moyen de commande (10) réagissant à une panne d'un amplificateur pour déconnecter l'amplificateur (LNA1, LNA2) d'avec la source de tension de fonctionnement, et en ce que le moyen d'alimentation en courant est apte à détecter un changement de consommation de courant résultant de la déconnexion de l'amplificateur d'avec la source de tension de fonctionnement et, de ce fait, la panne d'amplificateur (LNA1, LNA2).
